# EUROPEAN PATENT APPLICATION

(11) **EP 1 009 014 A2**
(43) Date of publication of application: **14.06.2000**
(21) Application number: 99309839.1
(22) Date of filing: 03.12.1999
(51) Int. Cl.: H01J 37/32, C23F 4/00

(54) **A plasma etching control device**

(30) Priority: 10.12.1998 GB 9827065
(71) Applicant: Orbis Technologies Ltd., Banbury, Oxfordshire OX16 8SW (GB)
(72) Inventor: Huggett, Paul Gideon, Upper Boddington, Daventry, NN11 6DJ (GB); Boyd, Matthew Stuart, Downend, Bristol BS16 6PR (GB)
(74) Representative: Stanley, Michael Gordon

(57) **Abstract**

An end point controller (12) and an interface unit (17) therefor, for use in an anisotropic plasma etching process comprising a series of alternating etching and polymerization steps, the controller (12) having a monitor (13) for monitoring the intensity of a characteristic process parameter, typically an optical emission, and producing a signal indicative of said intensity, the unit (17) or controller (16) having a timer assembly determining the operation of the monitor (13) during each etching step, the assembly comprising at least two sequential timers (100)(105), the first timer (100) determining a time lag (tl) between the onset of the etching step and the operation of the second timer (105) which sets a time period (t2) within the etching step for monitoring the selected parameter.

## Description

### Field

This invention relates to plasma etching control, in particular to an end point controller.

### Background of the Invention

In a process of selectively removing material from an exposed layer carried on a substrate, by plasma etching, the end point of the plasma etching process is typically detected by a method described in US-A-4528 438 in which an optical emission from the plasma is monitored in order to detect variations in the intensity of a selected optical intensity line. These changes indicate a change in material being etched and thus the completion of the etching of a particular material, or the beginning of etching another material.

The emission signal is continuously monitored over a time period during the etching process as is described in US-A-4936 967 . Any signal noise can be removed by a method as described in US-A-5208 644 to produce a relatively smooth curve in which the signal variations of the selected intensity line are seen as a change from a substantially constant value to a falling value reflected in the curve.

WO-A-93/25893 discloses an end point determination using the signal slope determinations at the start of the curve of the falling signal and at the lower end of the curve.

In a recent development, a method of anisotropically etching silicon is described in US-A-5501 893. In the process described the etching takes place through a series of alternating etching steps and polymerizing steps. In the etching step a silicon surface to be etched is contacted by a reactive gas to remove the exposed surface, and in the polymerising step a polymer contained in the plasma is deposited on to a silicon surface exposed in the previous etching step.

Since the etching process takes place in a series of spaced apart operations the end point control as described above cannot operate satisfactorily because of large signal variations in each discrete etching step, and between etching steps.

### Object of the Invention

The present invention provides a means for controlling the end point of a plasma etching process, in particular an anisotropic process.

### Statements of Invention

According to the invention there is provided an interface unit for an end point controller for an anisotropic plasma etching processor which operates in a series of alternating etching and polymerization steps, the controller having a monitor for monitoring the intensity of a characteristic process parameter and producing a signal indicative of said intensity, wherein the interface unit has a first connection with the controller to exchange signals therebetween, and a second connection with the processor to exchange signals therebetween, and a timer assembly determining the operation of the monitor, the assembly comprising at least two sequential timers, a first timer determining a time lag between the onset of the etching step and operation of a second timer which sets a time period within the etching step for monitoring the selected parameter.

Typical process parameters which are indicative of the plasma composition and which might be monitored include a) the optical emission from the plasma, b) the pressure of the gas discharge, c) the voltage in the plasma and d) the electric current in the plasma. In the preferred embodiment the optical emission is monitored during the etching step.

Such a unit may be a stand alone unit which is connected into the processor and end point controller or may be incorporated into an end point controller or etching processor .

The use of two timers is required because of the intensity of the selected parameter being unstable for a time period at the start of each etching step. A more stable signal is measured during the second time period.

According to another aspect of the present invention there is provided an end point controller for an anisotropic plasma etching process comprising a series of alternating etching and polymerization steps, the controller having a monitor for monitoring the intensity of a characteristic process parameter and producing a signal indicative of said intensity, and a timer assembly determining the operation of the monitor, the assembly comprising at least two sequential timers, a first timer determining a time lag between the onset of the etching step and the operation of a second timer which sets a time period within the etching step for monitoring the selected parameter.

Preferably the first and second timers are adjustable to allow said time lag and said time period to be set as is required for the process. Typically the two timers may be set for time intervals of between 0-60 or 0-30 seconds.

Also according to yet another aspect of the invention, there is provided a method of controlling the end point of a plasma etching process comprising a series of alternating etching and polymerization steps, the method comprising monitoring a characteristic process parameter, preferably an optical emission from the plasma, during each etching step, converting said parameter from each etching step into a measurable electrical signal, and processing the signal, wherein within each etching step of said alternating steps, the parameter is monitored for a predetermined time period which begins only after a predetermined time lag from the onset of the respective etching step.

Preferably the time lag between the onset of the etching step and start of the monitoring period is variable between 0-60 seconds and the time period for monitoring the parameter is also variable between 0-60 seconds.

Yet another aspect of the invention provides a method of determining the end point of a plasma etching process comprising a series of alternating etching and polymerization steps, the method comprising the conversion of a characteristic process parameter from each etching step into a measurable electrical signal and monitoring the signal for a predetermined time period within each etching step, said period beginning only after a predetermined time lag from the onset of the etching step, building up a curve comprising a plurality of discrete monitored signals, one from each respective step, and using the curve to determine the end point of the process.

### Description of Drawings

The invention will be described by way of example and with reference to the accompanying drawings in which :
- Fig 1: is a schematic drawing of the overall arrangement for the plasma etching end point control according to the present invention,
- Fig.2: is a block diagram of an interface unit according to the present invention, and
- Fig.3: is shows an idealised curve of emission intensity verses time during the etch steps.

### Detailed Description of the Invention

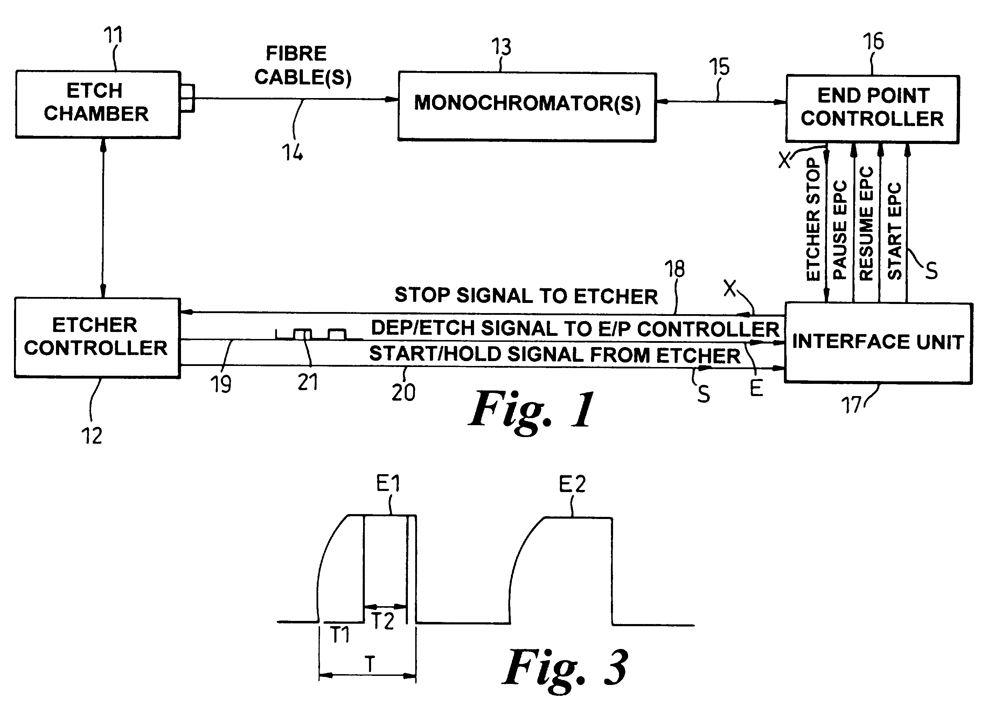

With reference to Figure 1 there is shown schematically a plasma etching process chamber 11 the operation of which is controlled by an etch process controller 12 in a manner as described in US-A-5501 893. An end point controller having at least one light sensor 13, and preferably two sensors as is described in US-A-5208 644, monitors the intensity of a particular optical emission spectral line via a respective fibre optic cable 14, for example the SiF2 line. A suitable controller is a model 9125 Optima, available from Luxtron of Santa Clara CA. The, or each, light sensor 13 is connected via cable 15 to a plasma etch end point controller 16.

An interface unit 17, according to the present invention is connected between the end point controller 16 and the etch process controller 12. The process controller 12 is connected to the interface unit 17 via at least three signal paths, an etch stop signal path 18 which relays a stop signal X from the unit 17, a deposit step /etch step signal path 19, and a start/hold signal path 20, both of which pass respective signals E and S to the unit 17.

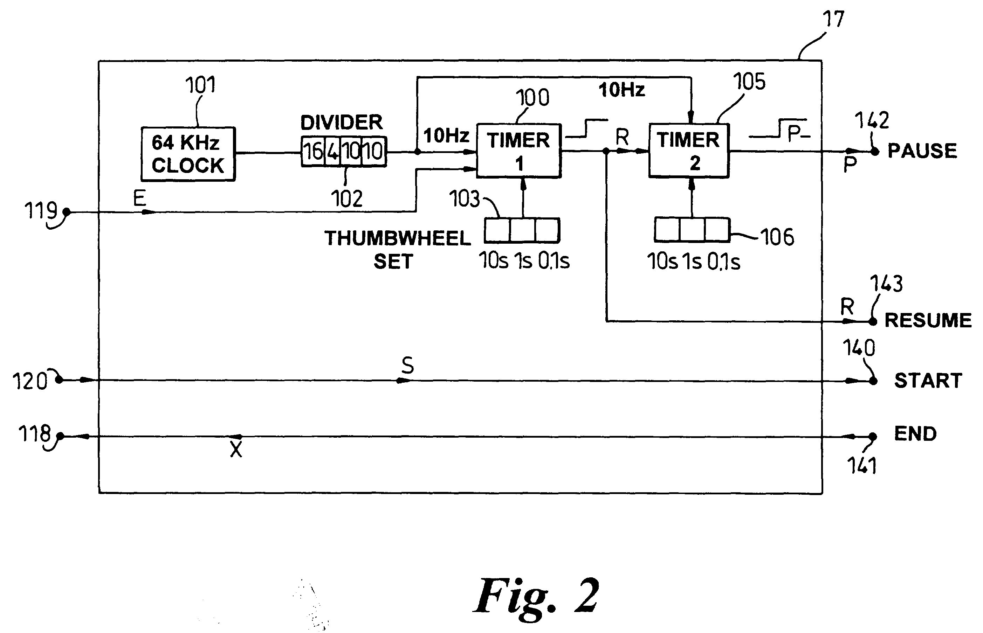

The interface unit 17 is shown in more detail in Fig.2. The start signal S from the process controller 12 enters the unit 17 through the signal path 20 via terminal 120 and passes through the unit to terminal 140 for connection to the end point control 16. Similarly the end or stop signal X from the control 16 enters the unit 17 via terminal 141 and exits the unit through terminal 118 for connection to the process control 12 via the signal path 18.

The deposit/etch signal E produced by the process control for operation of the etch chamber 11 is also utilised for operation of the unit 17. The signal E is fed by the signal path 19 to terminal 119 on the unit 17 so that unit 17 receives a series of pulsed signals represented in Fig. 1 at 21. The pulsed signal E, which is high during the etch step, is fed to a first timer 100 which receives a 10 Hz time signal from a 64 KHz clock 101 via a divider 102. The period for operation of the timer 100 is set by a thumb wheel set 103 having three thumbwheels for 10s, 1s and 0.1s, which can vary the time period from 0 - 60 seconds. The first timer 100 is connected to a second timer 105 which is preferably identical to the first timer 100. The second timer 105 is also connected to the clock 101, via the divider 102 to receive the 10Hz signal, and a respective thumbwheel set 106 as previously described.

The second timer 105 is connected to the end point controller 16 through terminal 142 to send a pulsed signal P, diagramatically shown at P,, to the controller. A further terminal 143 is connected to the output of the first timer 100 to receive an output signal R from the first timer.

The interface unit 17 operates as is described below. When the etching process starts the etcher control 12 sends a start signal S through the interface unit 17 to start the end point controller 16. The end point controller 16 then monitors a particular optical emission line in the etch chamber 11 through the optical sensor 13. The etch process controller 12 controls the etch chamber 11 to operate in a series of deposition and etch steps. The control signal for these steps is utilised by the interface unit which receives the pulsed signal E at terminal 119. The signal E goes high at the start of the etch step and triggers the first timer 100 into operation. At the end of the pre-set first time period T1 which is set using the thumbwheels 103, the first timer 100 passes a pulsed signal R to the second timer 105 and to the controller 16 via terminal 143. The pulsed signal R causes the controller 16 to monitor the optical sensor 13 and record the intensity of the light emission signal. At the end of the second pre-set time period, which was set by the second set of thumbwheeels 106, the second timer 105 passes a pulsed signal P to the end point controller 16 causing the controller to stop monitoring the optical sensor 13.

As the etch signal comprises a series of pulses E1, E2 etc., see Fig. 3, the timers 100 and 105 are operated in a series of distinct cycles each of which falls within the time period T of an etch step. For each signal E the controller 16 is caused to record the intensity of the chosen optical emission line of the etch plasma for only that time period T2 when the second timer 106 is switched on, after a lag time T1 from the start of each step. This lag is due to the fact that the emission is unstable for the first part of the etching step and then stabilises. The time period T2 falls within that portion of the etching step when the emission signal is more stable.

The end point controller 16 is programmed to use the spaced apart recordings of the optical emissions to build up a curve of the pulsed intensities for a particular emission line verses time for a particular spectral line. The actual end point is determined as is described in US 520 8644.

## Claims

1. An interface unit for an end point controller for an anisotropic plasma etching processor which operates in a series of alternating etching and polymerization steps, the controller having a monitor for monitoring the intensity of a characteristic process parameter and producing a signal indicative of said intensity, wherein the interface unit has a first connection with the controller to exchange signals therebetween, and a second connection with the processor to exchange signals therebetween, and a timer assembly determining the operation of the monitor, the assembly comprising at least two sequential timers, a first timer determining a time lag between the onset of the etching step and the operation of a second timer which sets a time period within the etching step for monitoring the selected parameter.

2. An interface unit as claimed in Claim 1, wherein the first timer is adjustable to vary said time lag.

3. An interface unit as claimed in Claim 1 or Claim 2, wherein the second timer is adjustable to vary said time period for monitoring.

4. An interface unit as claimed in any one of Claims 1 to 3, wherein each timer is variable to set a period of between 0-60 seconds.

5. An end point controller for anisotropic plasma etching which includes an interface unit as claimed in any one of Claims 1 to 4.

6. An end point control for an anisotropic plasma etching process comprising a series of alternating etching and polymerization steps, the controller having a monitor for monitoring the intensity of a characteristic process parameter and producing a signal indicative of said intensity, and a timer assembly controlling said monitoring, the assembly comprising at least two sequential timers, a first timer determining a time lag between the onset of the etching step and the operation of a second timer which sets a time period within the etching step for monitoring the selected parameter.

7. An end point controller as claimed in Claim 6, characterised in that the monitor comprises at least one light sensor which senses the intensity of optical emission from the plasma.

8. An end point controller as claimed in Claim 6 or Claim 7 and further including timers as claimed in Claims 2 to 4.

9. A method of controlling the end point of a plasma etching process comprising a series of alternating etching and polymerization steps, the method comprising monitoring a characteristic process parameter from each etching step, the converting said parameter into a measurable pulsed electrical signals and further processing said signals, wherein within each etching step of said alternating steps, the parameter is monitored for a predetermined time period which begins only after a predetermined time lag from the onset of the respective etching step.

10. A method as claimed in Claim 9, wherein the time lag may be varied as is required for a particular process.

11. A method as claimed in Claim 9 or Claim 10, wherein the time period for monitoring the etching step is varied as is required for a particular process.

12. A method as claimed in any one of Claims 9 to 11, wherein the monitored parameter is an optical emission of the plasma.

13. A method of determining the end point of a plasma etching process comprising a series of alternating etching and polymerization steps, the method comprising the conversion of a characteristic process parameter from each etching step into pulsed measurable electrical signals and within each etching step monitoring the signal for a predetermined time period which period begins only after a predetermined time lag from the onset of the respective etching step, then building up of a curve comprising a plurality of discrete monitored signals, one from each respective step, and using the curve to determine the end point of the process.
